# EUROPEAN PATENT APPLICATION

(11) **EP 4 832 044 A1**
(43) Date of publication of application: **28.10.2026**
(21) Application number: 24907358.6
(22) Date of filing: 16.12.2024
(51) Int. Cl.: H01J 37/20

(54) **SAMPLE HOLDER**

(30) Priority: 18.12.2023 JP 2023213400
(71) Applicant: Mel-Build Corporation, Fukuoka-shi, Fukuoka 819-0025 (JP)
(72) Inventor: MIYAZAKI Hiroya, Fukuoka-shi, Fukuoka 819-0025 (JP)
(74) Representative: Studio Torta S.p.A.
(86) International application number: PCT/JP2024/044384
(87) International publication number: WO 2025/134973

(57) **Abstract**

[Problem]

An object of the present invention is to provide a specimen holder that allows various observations.

[Solution]

The specimen holder of the present invention is characterized by comprising:
a specimen holder shaft portion having a specimen and/or specimen mesh mounting portion;
an outer cylinder portion capable of storing the specimen holder shaft portion;
a specimen holder handle portion mounted on the specimen holder shaft portion on the side opposite the specimen and/or specimen mesh mounting portion;
a seal portion;
a specimen holder tip portion, and
wherein the seal portion is present at the specimen holder tip portion and/or the outer cylinder portion, and when the specimen holder is installed on an electron microscope, a support portion through which at least an electrode or a flow path passes, at a position further outward from the center than the position of the goniometer stage of the electron microscope.

## Description

### Technical Field

The present invention relates to a specimen holder used for visualization, image formation, analysis, etc. of a specimen, and more particularly to a specimen holder used for observing a specimen under vacuum.

### Background Art

The need to observe and analyze specimens at the molecular and atomic level has led to the need for electron microscopy, which combines highly accurate imaging and analytical techniques under harsh conditions. For example, transmission electron microscopes (TEMs) are used to observe specimens under ultra-high or high vacuum.

As a specimen holder for positioning a specimen at an observation position of a TEM, for example, a specimen holder for a transmission electron microscope is known, which comprises: a specimen holder body having a first opening with a step formed therein; a specimen holding member that is rotatably housed within the first opening, with a portion of its periphery supported by the step, and has a second opening in its center for holding the specimen; and a cover member having an amorphous material film that covers the second opening except for at least a portion of the second opening (Patent Literature 1).

Also known is a cryogenic specimen holder for storing, cooling, and positioning a specimen in at least one imaging and analysis device, characterized in that it includes a container for storing and holding the specimen, a storage container for storing a liquid cooling medium having a collection point for the liquid cooling medium, a thermal conductor that is in thermal contact with the liquid cooling medium and the container regardless of the amount of the liquid cooling medium in the container and the spatial orientation of the storage container, the thermal conductor being in adjacent surface contact with the liquid cooling medium at the collection point, and an elongated barrel attached between the storage container and the container to position the specimen at a preselected location in at least one of the imaging and analysis devices (Patent Literature 2).

### Prior art literature

### Patent literature

Patent Literature 1 :JP-A-2007-179805
Patent Literature 2 :JP-A-2013-537689

### Summary of Invention

### Problems to be resolved by the invention

Conventional TEM specimen holders, including the one described in Patent literature 1, require the separation of the atmosphere and vacuum sides to prevent vacuum leakage through the holder within the TEM. Because observations with a transmission electron microscope are performed under high vacuum (high vacuum is preferred), it is necessary to locate the vacuum/atmosphere partition (sealing surface) as close to the tip of the holder as possible to minimize the volume or surface area to be evacuated. This results in spatial constraints on the design, as the specimen holder tip shaft either has a small diameter or the inner diameter is reduced due to the presence of a sealing member (e.g., an O-ring).

Furthermore, in recent years, as we strive for a decarbonized society, the shift to electric vehicles is progressing worldwide, and research and development into lithium-ion batteries is being conducted accordingly. Until now, due to various physical factors, it has been difficult to observe lithium-ion batteries under an electron microscope, and even leading companies both in Japan and overseas have been unable to achieve this.

Although a battery needs electricity to operate, as mentioned above, it was difficult to even observe a battery with an electron microscope, and it was even more difficult to pass electricity through it.

As described above, improvements in analytical technology and analytical demands have led to the need for specimen observation under a variety of conditions and environments. However, to meet these demands, sufficient space is required within the specimen holder, but in the past, it was difficult to secure sufficient space due to the aforementioned common sense in design.

In order to solve the above problems, an object of the present invention is to provide a specimen holder that allows various observations.

### Means of solving the problems

In order to achieve the above object, the present inventors have conducted extensive research into the degree of freedom in designing a device that can ensure a high vacuum, and as a result have come up with the present invention.

That is, the specimen holder of the present invention is characterized by comprising:
a specimen holder shaft portion having a specimen and/or specimen mesh mounting portion;
an outer cylinder portion capable of storing the specimen holder shaft portion;
a specimen holder handle portion mounted on the specimen holder shaft portion on the side opposite the specimen and/or specimen mesh mounting portion;
a seal portion;
a specimen holder tip portion, and
wherein the seal portion is present at the specimen holder tip portion and/or the outer cylinder portion, and when the specimen holder is installed on an electron microscope, a support portion through which at least an electrode or a flow path passes, at a position further outward from the center than the position of the goniometer stage of the electron microscope.

Further, in a preferred embodiment of the specimen holder of the present invention, it is characterized in that the specimen holder shaft portion has a groove.

Further, in a preferred embodiment of the specimen holder of the present invention, it is characterized in that the specimen holder tip portion is retractable into the outer cylinder portion.

Further, in a preferred embodiment of the specimen holder of the present invention, it is characterized in that further comprising a cooling portion capable of cooling the specimen holder shaft portion.

Further, in a preferred embodiment of the specimen holder of the present invention, it is characterized in that at least a part of the support portion is capable of transferring heat from the cooling portion to the specimen holder shaft portion.

In addition, in a preferred embodiment of the specimen holder of the present invention, it is characterized by further comprising a partition member that separates the inside of the outer cylinder portion from the atmosphere at a position further outward from the center than the position of a goniometer stage of the electron microscope when the specimen holder is installed in the electron microscope.

Further, in a preferred embodiment of the specimen holder of the present invention, it is characterized in that the partition member is installed at a connection portion between the outer cylinder portion and the specimen holder handle portion.

Further, in a preferred embodiment of the specimen holder of the present invention, it is characterized in that the partition member is disposed inside the specimen holder handle portion.

Further, in a preferred embodiment of the specimen holder of the present invention, it is characterized in that the specimen holder shaft portion is rotatable around the specimen holder axis.

Further, in a preferred embodiment of the specimen holder of the present invention, it is characterized in that the rotation allows the specimen and/or specimen mesh mounting portion to rotate around the axis of the specimen holder shaft portion or around an axis perpendicular to the axial direction of the specimen holder shaft portion.

Further, in a preferred embodiment of the specimen holder of the present invention, it is characterized in that an outer wall surface of the specimen holder shaft portion and an inner wall surface of the outer cylinder portion are mirror-finished.

### Effect of Invention

The specimen holder of the present invention has the advantageous effect of being able to isolate the specimen and/or specimen mesh mounting area from the atmosphere during transfer, and functioning as a transfer holder. Furthermore, the specimen holder of the present invention has the advantageous effect of being able to evacuate the specimen holder by utilizing the vacuum evacuation on the electron microscope side.

### Brief description of the drawings

[Figure 1] FIG. 1 is a figure showing a side cross-sectional view of a specimen holder according to one embodiment of the present invention.
[Figure 2] FIG. 2 is a figure showing a side cross-sectional view of a specimen holder in one embodiment of the present invention (when the tip of the specimen holder is retracted).
[Figure 3] FIG. 3 is a figure showing a perspective view of a specimen holder according to an embodiment of the present invention.
[Figure 4] FIG. 4 is a figure showing a perspective view of the tip of a specimen holder in one embodiment of the present invention.
[Figure 5] FIG. 5 is a figure showing a perspective view of the specimen holder tip in one embodiment of the present invention. It shows the specimen holder tip retracted in one example.

### Mode for Carrying Out the Invention

The specimen holder of the present invention is characterized by comprising:
a specimen holder shaft portion having a specimen and/or specimen mesh mounting portion (or semiconductor device chip);
an outer cylinder portion capable of storing the specimen holder shaft portion;
a specimen holder handle portion mounted on the specimen holder shaft portion on the side opposite the specimen and/or specimen mesh mounting portion;
a seal portion;
a specimen holder tip portion, and
wherein the seal portion is present at the specimen holder tip portion and/or the outer cylinder portion, and when the specimen holder is installed on an electron microscope, a support portion through which at least an electrode or a flow path passes, at a position further outward from the center than the position of the goniometer stage of the electron microscope. The specimen holder shaft portion having the specimen and/or specimen mesh mounting portion is not particularly limited, and may have only the specimen mounting portion on which the specimen is mounted. Further the specimen holder shaft portion may also have a semiconductor device chip. In the present invention, the seal portion is present at the tip of the specimen holder and/or the outer cylinder portion. By providing the seal portion at the specimen holder tip portion and/or the outer cylinder portion (outer casing), a flow path is secured in front of the specimen holder shaft portion so that the inside of the holder can be evacuated using the vacuum evacuation of the electron microscope during specimen observation, as described below. This allows for the specimen holder to be evacuated, and when the specimen holder tip portion is stored during transport, the inside of the specimen holder can be isolated from the outside air, etc., thereby providing the advantageous effect of being usable as a transfer holder.

Furthermore, in the present invention, when the specimen holder is installed in an electron microscope, a support portion through which at least an electrode or a flow path passes is provided at a position further outward from the center than the position of the goniometer stage of the electron microscope. In the present invention, the support portion is not particularly limited as long as it is capable of passing at least an electrode or a flow path. The support portion can also support the specimen holder shaft portion, and when a cooling portion as described below is used, it can be capable of transferring heat from the cooling portion. Furthermore, when a cooling portion is not required, the support portion can also be used in combination with a barrier member as described below.

Further, in a preferred embodiment of the specimen holder of the present invention, it is characterized in that the specimen holder shaft portion has a groove. In the present invention, for example, when applying current, the groove can be cut along the axis, and wiring can be fixed to the groove and linked to the shaft. For example, as described below, when storing the specimen holder tip portion, the wiring can be smoothly stored together with the groove.

Further, in a preferred embodiment of the specimen holder of the present invention, it is characterized in that the specimen holder tip portion is retractable into the outer cylinder portion. When the specimen holder tip portion is stored in the outer cylinder portion, a seal portion at the specimen holder tip portion and/or the outer cylinder portion can isolate the inside of the specimen holder from the outside air, thereby enabling the holder to function as a holder not exposed to the atmosphere. The seal portion does not act as a barrier when using the vacuum evacuation on the electron microscope side during specimen observation, and therefore its role differs from that of conventional seals, even if their location is similar.

In other words, in the past, due to excessive emphasis on vacuum and due to polishing technology and other factors, it was common technical knowledge that the seal position should be as close to the front of the specimen holder (towards the center of the microscope) as possible. However, in conventional technology, the idea of using vacuum exhaust on the electron microscope side did not exist, and from the perspective of reducing the volume to be evacuated, it was assumed that the seal portion would be located as close to the tip holder portion as possible, and that a separate vacuum would be drawn from the specimen holder handle side comparing with the location of the seal portion.

In the prior art, the seal remains active throughout the entire process, making it impossible to use evacuation from the electron microscope side, but in the present invention, the specimen holder tip portion is not retracted into the outer cylinder portion during specimen observation, so the seal does not function, allowing evacuation from the electron microscope side to be used. However, the seal portion can still function when the specimen holder tip portion is retracted, making it possible to use the specimen holder as a holder that is not exposed to the atmosphere. This offers the advantageous effect of allowing the specimen holder to be placed in a vacuum or Ar atmosphere inside while not being exposed to the atmosphere, allowing for vacuum or Ar transfer of the specimen holder.

Further, in a preferred embodiment of the specimen holder of the present invention, it is characterized in that further comprising a cooling portion capable of cooling the specimen holder shaft portion. The location of the cooling portion (unit) is not particularly limited. More specifically, the cooling portion can be located, for example, in the direction of the specimen holder handle portion, preferably in front of the handle portion. The cooling portion can use liquid nitrogen, liquid helium, or the like to cool the specimen holder shaft portion and, ultimately, the specimen.

Furthermore, the Dewar evacuation method using the specimen holder, which is an example of a preferred embodiment of the present invention, makes it possible to draw a vacuum in the entire TEM, etc. That is, the evacuation method of the present invention is characterized by using the vacuum evacuation on the TEM side to draw a vacuum.

The method for evacuating the Dewar part of the existing cooling holder (specimen holder) is as follows.
1. Heat the Zeolite 95 under vacuum for approximately 3 hours. Wait for approximately 3 hours for it to return to room temperature.
2. Insert the specimen holder into the TEM or other device.
3. Pour liquid nitrogen into the cooling container.
4. By adding liquid nitrogen, the zeolite 95 absorbs the molecules, increasing the degree of vacuum in the Dewar, providing vacuum insulation and cooling.

However, the existing methods for maintaining a vacuum in the Dewar section have the following problems.
1. The adsorption capacity of zeolite gradually decreases with cooling time, limiting the number of times it can be refilled with liquid nitrogen.
2. Because the degree of vacuum is unstable, changes occur over time in the heat transfer from the outside to the axis, and thermal drift is unstable, making it difficult to obtain data at high resolution (atomic resolution) using TEM and other imaging techniques due to thermal drift.
3. Also, vacuum insulation is required between the TEM side and the Dewar side, so a seal member is always required, but heat flows into the axis from the seal portion, which also affects thermal drift. Also, because of the heat input, it takes longer to reach a cooling point and the reached temperature also increases.
4. Because the adsorption capacity of the zeolite becomes saturated, the zeolite must be vacuum heated after the observation is completed, and it takes approximately 6 hours from the end of the observation until the next observation.

In contrast, as described above, the Dewar vacuum method using the specimen holder of the present invention makes it possible to draw a vacuum in all TEMs, etc. That is, the vacuum drawing method of the present invention is a method of drawing a vacuum in the specimen holder of the present invention inside an electron microscope, and is characterized by using the vacuum exhaust on the electron microscope side to draw a vacuum.

That is, the advantages of the vacuum method using the specimen holder according to the embodiment of the present invention are as follows.
1. There is no need to use a seal portion, and there is no need to evacuate the cooling side and the specimen holder tip portion separately. As a result, the same degree of vacuum can be maintained everywhere, so there is no effect from uneven radiant heat (heat from the external environment). (All radiant heat is uniform.)
2. Because there is no sealing portion along the way, the heat input from the equipment side such as TEM is very small.
3. Due to the advantages mentioned above, the temperature stability of the heat transfer axis is significantly improved, reducing the effects of thermal drift. This vacuum method reduces the heat input to the specimen holder and the effects of radiant heat, allowing stable acquisition of high-resolution images even when cooled.
4. Additional effect: In TEM etc., the preparatory preparation of zeolite for vacuuming is unnecessary because all vacuums are drawn. The specimen holder of the present invention can be cooled immediately after returning to room temperature, making it possible to observe multiple times a day.

Moreover, strictly speaking, the absence of a seal portion means that, when observing a specimen, the specimen holder tip portion is not retracted into the outer cylinder portion of the specimen holder, and the seal that separates the inside and outside of the specimen holder is not functioning. This means that the specimen holder is not sealed, making it possible to evacuate the entire interior of the specimen holder in a TEM or other instrument. When using vacuum evacuation on the electron microscope side during specimen observation, a seal portion (also called a second seal portion or barrier member) that seals the motor connecting shaft can be installed just before the handle portion or between the cooling dewar casing and the retracting handle portion for cooling. This allows the inside of the specimen holder to be evacuated using the vacuum on the electron microscope side while isolating it from the outside air. Alternatively, the seal portion may be located between the holder shaft and the cooling dewar casing for cooling. While the seal portion is typically located on the outside of the holder shaft, the former is preferred as an embodiment.

Moreover, the material for the seal portion or the partition member described below can be polytetrafluoroethylene or a high-performance fluorinated rubber material such as fluorosilicone. Polytetrafluoroethylene has very high cold resistance and also high thermal insulation. Therefore, if the seal portion is made of a cold-resistant material, observations under cooled conditions can be performed under a securely sealed condition.

Further, in a preferred embodiment of the specimen holder of the present invention, it is characterized in that at least a part of the support portion is capable of transferring heat from the cooling portion to the specimen holder shaft portion. The support portion can be in contact with the cooling portion (unit). In this case, heat from the cooling portion can be transferred to the specimen holder shaft portion. In this case, the support portion not only can support the specimen holder but also can transfer heat from the cooling portion to the specimen holder shaft portion. In the present invention, the material of the support portion when conducting heat is not particularly limited as long as it can conduct heat efficiently, and examples can include copper alloy, pure copper, A7075, etc. Other materials that can be used include copper mixed with (STC) carbon and any material with good thermal conductivity that can be machined.

Moreover, the cooling portion may also include a heat-conducting portion (section). For example, when liquid nitrogen or the like is used, the cooling portion can be configured to connect the bottom of the liquid nitrogen container to the specimen holder shaft portion with a heat-conducting portion made of a heat-conducting material. This allows the liquid nitrogen temperature to be transferred to the specimen holder shaft portion and ultimately to the specimen until the liquid nitrogen is completely depleted. When a heat-conducting portion and a support portion are used together, a part of the support portion acts as a heat-conducting portion, allowing the heat from the cooling portion to be transferred to the specimen holder shaft portion as described above. Thus, when the present invention is applied to a cooling holder, the coolant in the Dewar section can be retained longer, and a high vacuum can be maintained with stable heat transfer, resulting in the advantageous effect of improving temperature stability.

Moreover, in a preferred embodiment of the specimen holder of the present invention, it is characterized by further comprising a partition member that separates the inside of the outer cylinder portion from the atmosphere at a position further outward from the center than the position of a goniometer stage of the electron microscope when the specimen holder is installed in the electron microscope. In the present invention, arranging the partition member at a position further outward from the center of the electron microscope than the position of the goniometer stage of the electron microscope offers various advantages. In other words, in the past, due to considerations such as polishing technology, it was necessary to position the seal as close to the front of the specimen holder (toward the center of the microscope) as possible. This is because the inner wall of the specimen holder needs to be polished, which is difficult. Therefore, due to the need to polish the minimum surface area, it was conceptualized that the specimen holder should be located closer to the front (toward the center of the microscope). In reality, the farther the specimen holder is located, the more likely it is to cause malfunctions in the microscope, specimen holder, and other devices. In addition, the partition member is not particularly limited as long as it can isolate the inside of the outer cylinder portion from the atmosphere. Examples of partition members can include sealing members and encapsulation materials, and specifically, O-rings.

In addition, in the present invention, there is also a seal for storing the specimen holder tip portion, but this seal does not function when observing the specimen, and does not interfere with vacuuming on the electron microscope side, which is a major difference from conventional perspectives.

In the present invention, by arranging the partition member at a position further outward from the center of the electron microscope than the position of the goniometer stage of the electron microscope, it becomes possible to effectively utilize the internal space between the specimen holder shaft portion and the outer cylinder portion. Conventionally, a barrier member existed in the internal space between the specimen holder shaft portion and the outer cylinder portion, preventing the space from being effectively utilized.

Furthermore, by arranging the partition member at a position further outward from the center of the electron microscope than the position of the goniometer stage of the electron microscope, when the barrier member is used in combination with a hermetic seal or the like, as will be described later, it becomes possible to effectively utilize the relatively large space that exists at a position further outward from the position of the center of the electron microscope than the goniometer stage of the electron microscope. This improves the design freedom in the present invention, and ultimately makes it possible to improve the performance of the specimen holder itself. Specifically, the present invention makes it possible to dramatically improve the performance of specimen holders with built-in electrodes, specimen holders with built-in flow channels, and specimen holders for cooling, etc. In other words, in the present invention, the large space inside the shaft can be effectively utilized, and the partition member can be arranged in a relatively large space at an outer position, so that the space around the partition member can be utilized, resulting in the advantageous effect of providing high design freedom and significantly improving the workability of wiring, etc.

In other words, in the past, due to excessive emphasis on vacuum and due to considerations of polishing technology, etc., it was common technical knowledge that it was essential to position the seal as close to the front of the specimen holder (towards the center side of the microscope) as possible. However, contrary to this common technical knowledge, we attempted a change of thinking and came up with the present invention.

In addition, the specimen holder to which the present invention can be applied is not particularly limited. For example, the present invention can be applied to a single-axis tilt specimen holder, a two-axis tilt specimen holder, an electric field holder, a magnetic field holder, a heating holder, or a so-called cooling specimen holder having a cooling portion, or a cooling holder with a two-axis tilt mechanism.

Further, in a preferred embodiment of the specimen holder of the present invention, it is characterized in that an outer wall surface of the specimen holder shaft portion and an inner wall surface of the outer cylinder portion are mirror-finished. The outer wall surface of the specimen holder shaft portion and the inner wall surface of the outer cylinder portion of the present invention can be mirror-finished, and by adopting such a configuration, it is possible to obtain the advantages described below in so-called "vacuum drawing."

Depending on the shape and specifications of the specimen holder components, the mirror finish may be performed using, for example, buffing, hand polishing, or other polishing methods, or a combination of multiple polishing methods. The mirror finish preferably includes internal steps, bores, screw holes, grooves, and other fine areas not previously considered. Furthermore, the surface roughness achieved by the mirror finish, in terms of arithmetic mean roughness (Ra), is preferably in the range of 0.2 µm to 1 µm, and more preferably not exceeding 0.2 µm. Polishing the inside of the holder shaft portion to a mirror finish in this way advantageously avoids placing excessive strain on the TEM's vacuum pumping system and allows for the achievement of the specified high vacuum. By polishing the inside of the holder shaft portion to a mirror finish in this way, this offers the advantage of being able to achieve the specified high vacuum value without placing an excessive load on the TEM's vacuum evacuation system.

Further, in a preferred embodiment of the specimen holder of the present invention, the partition member may be installed at a connection portion between the outer cylinder portion and the specimen holder handle portion. There are no particular limitations on the location of the partition member as long as it can be located at a position further outward from the center of the electron microscope than the position of the goniometer stage of the electron microscope, but installing the partition member at the connection portion makes it possible to ensure more space inside the shaft and in the handle portion.

Further, in a preferred embodiment of the present invention, the partition member may be disposed inside the specimen holder handle portion. In this case, the hermetic portion is virtually free of spatial constraints, allowing for a wider and larger design. While the term "hermetic" generally refers to an airtight sealing structure that blocks external air, in the present invention it is interpreted more broadly and can be used as a support member for passing electrodes, flow paths, etc. The partition member may also serve as a hermetic member, allowing at least electrical wiring or fluid piping to pass through it. While this was previously nearly impossible due to the specimen holder's operating conditions (heating, fluid flow, application of an electric field, light/laser irradiation, and combinations thereof) corresponding to the specimen observation conditions in the prior art, the present invention allows for the passage of a total of eight or more electrical wiring and fluid piping lines through the hermetic member.

In a preferred embodiment, the specimen holder shaft portion can be made rotatable around the specimen holder axis (shaft). This is also called X-axis tilt, α-tilt, or uniaxial tilt. Generally, this can be performed using a device on the TEM side, but in the present invention, X-axis tilt is also possible on the specimen holder side. By making the specimen holder rotatable around the specimen holder shaft, the specimen and/or specimen mesh mounting part can also be made rotatable around the specimen holder shaft, making it possible to observe the specimen while it is rotated. Rotation can be performed by any conventional method and is not particularly limited. More specifically, for example, rotation can be performed using the specimen holder handle portion.

Further, in a preferred embodiment of the present invention, the rotation can allow the specimen and/or specimen mesh mounting portion to rotate around the axis of the specimen holder shaft portion as described above, as well as around an axis perpendicular to the axial direction of the specimen holder shaft portion. The mechanism for allowing rotation around an axis perpendicular to the axial direction of the specimen holder shaft portion may be a conventional mechanism and is not particularly limited. In a preferred embodiment, the rotation around the axis perpendicular to the axial direction of the specimen holder shaft portion may be performed via an offset cam mechanism.

Even when the specimen holder is for cooling, the position of the partition member is not particularly limited. The partition member can be installed at any location, such as the connection portion between the cooling portion (Dewar unit) and the handle portion, near the connection portion between the cooling section and the outer cylinder section on the side facing the center of the microscope, or at the bottom, middle, or top of the Dewar unit.

Furthermore, by incorporating a MEMS (Micro Electro Mechanical System) chip, the specimen to be observed can be subjected to heating, current application, tension, and other conditions, each without exposure to air and under cooling. This allows observations to be performed while controlling basic physical quantities using a single holder. Note that MEMS (Micro Electro Mechanical System) chips are an abbreviation for microelectromechanical systems, a general term for devices in which mechanical elements such as sensors, actuators, and heaters are integrated into a microscopic area on a semiconductor substrate such as silicon or a glass substrate using microfabrication techniques. Conventional methods can be incorporated into the present invention, without particular limitations. Electrical circuits and mechanical structures are incorporated within micron-sized areas, and in the field of electron microscopy, in particular, they are an effective method for reproducibly controlling physical parameters such as current application, heating, and stress application on specimens measuring several micrometers to several millimeters under constraints such as small spaces and high vacuum conditions. Conventional methods can also be applied to the present invention.

In addition, in the case of heating, the chip can be heated by forming a heater pattern on the chip and passing an electric current through it. The heater pattern can be a conventional one and is not particularly limited, and as examples thereof mention may be made of a spiral, wave, honeycomb, etc. As the heater pattern, a pattern that cancels out magnetic fields generated by current flow and a pattern that heats evenly are desirable.

In addition, when applying electricity, by creating a pattern of electrodes (positive and negative) on both sides of a space such as a slit, placing the specimen across the slit (any suitable space will do) and applying voltage, it is possible to apply voltage between the electrodes or pass current through the electrodes.

In the case of tension, a tensile stress can be applied to a specimen by creating an actuator that operates when electricity is passed through it and patterning it into a chip shape.

### Example

While the following describes examples of the specimen holder of the present invention with reference to the drawings, the present invention is not limited to these examples and can, of course, be modified as needed without departing from the spirit and scope of the present invention.

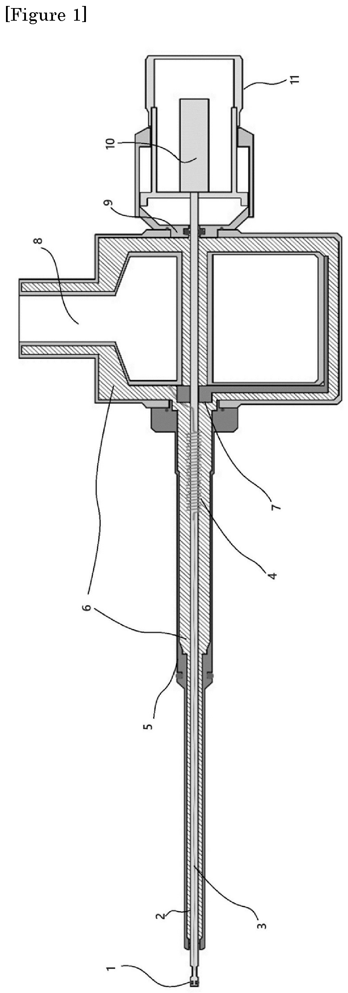

FIG. 1 is a figure showing a side cross-sectional view of a specimen holder according to one embodiment of the present invention. In FIG. 1, reference numeral 1 denotes a seal portion, 2 denotes a specimen holder shaft portion (rotation axis), 3 denotes a current-carrying wire, 4 denotes a current-carrying wire extension/retraction portion, 5 denotes an outer cylinder portion, 6 denotes a vacuum region, 7 denotes a support portion, 8 denotes a cooling portion (Dewar portion), 9 denotes a second seal portion, 10 denotes a shaft-tilting motor, and 11 denotes a handle portion, respectively. Although not shown, a specimen mounting portion is located between the handle portion side of the seal portion 1 and the tip of the outer cylinder portion 5 on the electron microscope side. Alternatively, the specimen mounting portion may be a specimen mesh mounting portion, or a combination of a specimen mounting portion and a specimen mesh mounting portion may be used. When the specimen holder tip portion is retracted, the spring-shaped current-carrying wire extension/retraction portion 4 can be extended and retracted.

FIG. 1 is a figure showing a schematic diagram of a specimen during observation. When a specimen holder is set in the electron microscope, a vacuum region 6 identical to the vacuum of the TEM can be achieved by utilizing the vacuum evacuation on the electron microscope side (TEM). That is, for example, as shown in the figure, a second seal portion 9 can be installed at a position outside the goniometer stage of the electron microscope. When the vacuum evacuation on the electron microscope side (TEM) is utilized, the vacuum region 6 can be the same as the vacuum of the TEM. The second seal portion (also referred to as a barrier member) may be located, for example, just before the handle portion 11, or even inside the handle portion 11. On the other hand, the closer the seal position is to the handle portion 11 from the outer cylinder portion 5, the larger the space becomes, which increases the so-called vacuum volume and places a strain on the TEM's vacuum evacuation system. That is, in the conventional configuration where a seal member is installed at the tip portion, simply moving the seal closer to the handle portion makes it even more difficult to achieve the specified value when drawing a vacuum, but this can be addressed by polishing the inside of the holder shaft portion to a mirror finish to the extent that there are no problems with drawing a vacuum. More details on mirror finishes will be provided later.

In addition ,in the embodiment of the present invention, as an example, liquid nitrogen may be used as the refrigerant in the container of the cooling portion (Dewar unit) 8.

In addition, in a mode where cooling is possible, a cooled refrigerant can be used. For example, when liquid nitrogen is used, if a normal O-ring is used in a normal manner, the O-ring will harden at the liquid nitrogen temperature, and the metal will shrink as the temperature drops, making it impossible to achieve a vacuum seal (external seal) with a specimen holder that uses liquid nitrogen temperature.

However, if a cold-resistant material such as polytetrafluoroethylene is used as the sealing material, the sealing performance will be excellent even under liquid nitrogen, since polytetrafluoroethylene sealing materials are durable down to temperatures of -200°C or below.

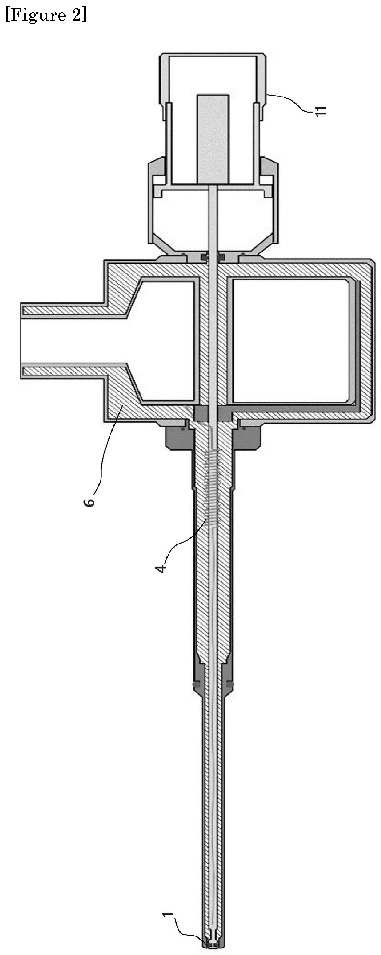

Figure 2 is a figure showing a side cross-sectional view of a specimen holder according to one embodiment of the present invention (when the specimen holder tip portion is retracted). In Figure 2, 1 denotes a seal portion, 4 denotes an expandable current-carrying wiring portion, 6 denotes a vacuum region, and 11 denotes a handle portion, respectively. Figure 2 shows the specimen holder tip portion containing a specimen retracted within the outer cylinder portion of the specimen holder. By retracting the specimen holder tip portion, the scope of the region 6 such as vacuum can be maintained with argon or vacuum, and vacuum transfer is also possible. As shown in Figures 1 and 2, the handle portion 11 can be moved parallel to the longitudinal direction of the specimen holder, allowing the specimen holder tip portion to be retracted along with the wiring. In this way, the inside of the dewar and the TEM holder can be maintained at the same vacuum. Furthermore, as described below, it is possible to provide a feedthrough in the dewar portion. This allows for current application, cooling, biaxial tilting, and atmospheric non-exposure to be achieved with a single specimen holder.

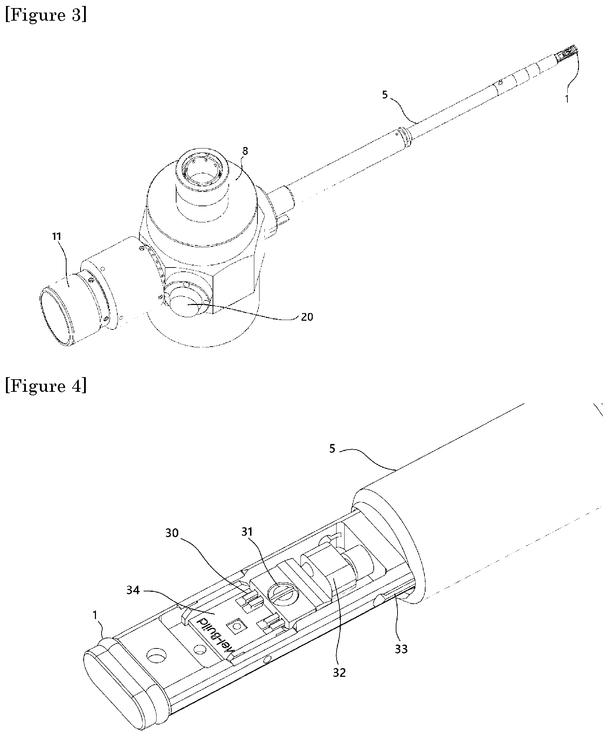

Figure 3 is a figure showing a perspective view of a specimen holder according to one embodiment of the present invention. In Figure 3, 1 denotes a seal portion, 5 denotes an outer cylinder portion, 8 denotes a cooling portion (Dewar portion), 11 denotes a handle portion, and 20 denotes a feed-through portion, respectively. Figure 3 shows the specimen holder tip portion when not retracted, with the seal portion 1 visible. In this embodiment, a feed-through portion for wiring can be provided on the Dewar side. When installing a feed-through portion to the cooling portion, wiring from the support portion can be routed to the feed-through portion by running the wiring along a holder shaft having a groove or the like. In this embodiment, an electrode can be placed at the tip while maintaining the retracted, i.e., non-exposed to the atmosphere, function. In this case, the structure of the electrode is not particularly limited.

Moreover, in this example, the field-through portion (hermetic) is provided on the cooling portion side, but the second seal portion and/or field-through portion may be provided at the connection portion between the outer cylinder portion and the specimen holder handle portion. In this case, the specimen holder shaft portion (rotation axis) and the lead wires can pass through the hermetic section. Depending on the conditions of use of the specimen holder (heating, fluid flow, application of an electric field, light/laser irradiation, or a combination thereof), multiple components can pass through the hermetic section.

Furthermore, although not shown, a sealing surface including a second sealing portion may be provided further back in the handle portion. The second sealing portion may also be part of the hermetic seal. In this example, by locating the sealing surface in a larger space outside the goniometer stage of the electron microscope, there are almost no spatial constraints on the hermetic seal, allowing for a larger and wider design. When introducing a fluid (gas, liquid) into the holder, a pipe or the like may be incorporated as a flow path, but the structure of this example allows for easy design without worrying about interference with the flow path and/or electrodes and related components.

On the other hand, as the sealing surface is moved further away from the center of the electron microscope outside the goniometer stage, the volume of the vacuum pumped by the electron microscope increases, which may place a strain on the vacuum pumping system of the electron microscope.

In such cases, a high vacuum can be achieved by polishing the inside of the holder shaft portion to a mirror finish over as wide an area as possible. In this case, it is preferable to mirror-finish at least the inner surface of the outer cylinder portion. The mirror-finished area should include small areas that have not been covered in the past, such as internal steps part, and the smaller the area that is not mirror-finished, the better.

Moreover, depending on the shape and specifications of the specimen holder components, mirror finishing may be performed by, for example, buffing, hand polishing, or other polishing methods, or by a combination of multiple polishing methods. Furthermore, it is preferable that the surface roughness of the mirror finish does not exceed 0.2 µm in terms of arithmetic mean roughness Ra. If Ra exceeds 1, it becomes practically difficult to continue evacuating the Dewar section using the TEM's evacuation system. In other words, if Ra exceeds 1, it will take a long time to evacuate the Dewar section using the TEM's evacuation system, which may cause practical inconvenience.

Next, an embodiment in which the specimen holder of the present invention is used in a TEM to perform so-called vacuuming will be described. In particular, an example in which the specimen holder of the present invention is used to cool a specimen will be described. When the Dewar vacuum method is performed on the specimen holder of the present invention, the area to which the vacuum extends is as shown in the vacuum region 6 in Figure 1 . That is, the area to which the vacuum extends on the specimen holder of the present invention is as shown in region 6 in Figures 1 and 2 . When the entire specimen holder is vacuum pumped in a TEM, the same practical vacuum level can be maintained throughout the entire region from the inside of the Dewar housing between the shaft portion and the outer cylinder portion, so there is no impact from uneven radiant heat on the specimen holder. In other words, the radiant heat received by the specimen holder is substantially uniform. Furthermore, since there is no seal inside the outer cylinder portion, as in the prior art, the heat input from the TEM or other equipment to the specimen holder 10 can be greatly reduced. Furthermore, the specimen holder of the present invention does not require the heating and evacuation of Zeolum, which was a preliminary step in the prior art.

Furthermore, when the specimen holder of the present invention is used for cooling, the inside of the dewar can be made to have the same degree of vacuum as that of a microscope, which not only improves the retention of liquid nitrogen, but also, when a heat-conducting member or the like is installed between the specimen holder shaft portion and the cooling portion, the heat-conducting member can also be stably maintained at a high vacuum, thereby improving temperature stability.

Next, Figure 4 is a figure showing a perspective view of the specimen holder tip portion in one embodiment of the present invention. In Figure 4, 1 denotes a seal portion, 5 denotes an outer cylinder portion, 30 denotes an electrode, 31 denotes an electrode fixing screw, 32 denotes a two-axis tilt cam structure, 33 denotes a groove, and 34 denotes a tip, respectively. In the present invention, a tip or cartridge 34 can be used to install the specimen on the specimen mounting stage at the specimen holder tip portion. It is also possible to fix the tip 34 using an electrode 30. The electrode 30 may be fixed to the specimen mounting stage using an electrode fixing screw 31. In this example, a cam structure 32 for two-axis tilting can also be provided, and the specimen can be tilted two-axis by using the specimen holder shaft portion, handle portion, etc. In addition, a groove 33 is designed from the side surface of the specimen holder tip portion to the side surface of the specimen holder shaft portion, and wiring can be fixed in this groove, so that the wiring, etc., of the specimen holder tip portion can be stored together with the specimen holder tip portion. For example, the groove 33 can be installed up to the current-carrying wiring extension part 4 in Figure 1.

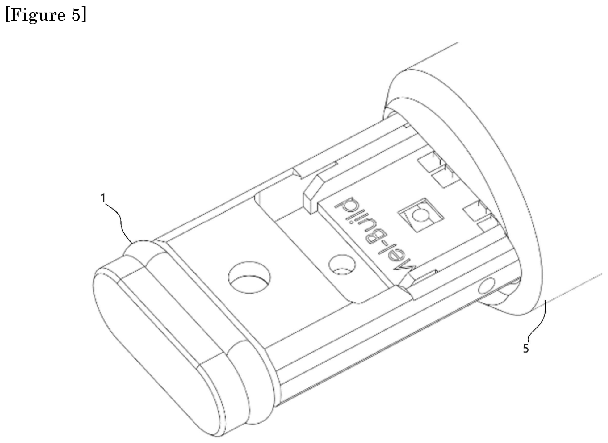

Fig. 5 is a figure showing a perspective view of the specimen holder tip portion in one embodiment of the present invention. It is a diagram showing the state in which the specimen holder tip portion is stored in one example. In Fig. 5, 1 indicates a seal portion and 5 indicates an outer cylindrical portion, respectively. Note that, although an O-ring is arranged at the tip portion in the figure, an O-ring may be embedded (arranged) inside the front of the outer cylindrical portion of the specimen holder.

Thus, in the present invention, the vacuum of the Dewer and the TEM can be made the same to achieve air non-exposure while cooling and energizing. Furthermore, by the specimen base with electrodes located on a retractable shaft (axis) being stored at the tip portion along with the wiring that carries electricity, this makes it possible to allow the tip to be retracted, thereby realizing a non-air-exposed cooling holder that can be cooled with liquid nitrogen. In other words, in the present invention, by making the vacuum of the Dewer and the TEM the same, the difference in the influence of radiant heat when cooling is eliminated, thereby preventing thermal drift due to cooling. Since there is no difference in the influence of radiant heat when controlling the temperature, more advanced temperature control is possible, and thermal expansion can be prevented at the nanometer level.

In this invention, by observing changes in a material caused by heating (directly below) a specimen, applying an electric field, or passing an electric current in the vicinity of the specimen using a transmission electron microscope, etc., it is possible to clarify the state of phase transformation, changes in atomic positions, and electrochemical behavior at the microscopic level. In addition, by spraying gas near the specimen or flowing a fluid such as gas in a space separated from the vacuum, it is possible to perform electron microscope observations in almost real environments.

As described above, the specimen holder of the present invention locates the seal portion (and/or hermetic) closer to the handle potion, i.e., in a large open area, thereby dramatically simplifying design, wiring and assembly work, as well as maintenance.

Furthermore, by mirror-finishing the desired inner surface of the specimen holder according to the condition of the vacuum exhaust system, the TEM's vacuum exhaust system can continue to pump air. This reduces the frequency of refrigerant refills due to deterioration in performance, significantly shortening the time until data acquisition for the specimen. Therefore, the specimen holder of the present invention can dramatically improve productivity in specimen handling. Furthermore, the mirror-finished inner surface allows the heat transfer component to be stably maintained at a high vacuum, improving temperature stability. Thus, the specimen holder of the present invention is expected to make a significant contribution to the development of various research fields.

### Industrial applicability

The specimen holder of the present invention is suitable for use under high vacuum conditions and is expected to be useful in a wide range of fields. The specimen holder of the present invention enables highly accurate visualization, image formation, and analysis of specimens under high vacuum conditions, and is expected to make a significant contribution to the development of research.

### Explanation of symbols

- 1: Sealing portion, Specimen and/or specimen mesh mounting portion
- 2: Specimen holder shaft (rotation axis)
- 3: Wiring for energizing
- 4: Electrical wiring extension part
- 5: Outer cylinder portion
- 6: Areas such as vacuum
- 7: Support portion
- 8: Cooling portion (Dewar unit)
- 9: Second seal portion
- 10: Axis tilt motor
- 11: Handle portion
- 20: Feedthrough portion (section)
- 30: Electrode
- 31: Electrode fixing screw
- 32: Two-axis tilt cam structure
- 33: Groove
- 34: Chip

## Claims

1. A specimen holder comprises:
a specimen holder shaft portion having a specimen and/or specimen mesh mounting portion;
an outer cylinder portion capable of storing the specimen holder shaft portion;
a specimen holder handle portion mounted on the specimen holder shaft portion on the side opposite the specimen and/or specimen mesh mounting portion;
a seal portion;
a specimen holder tip portion, and
wherein the seal portion is present at the specimen holder tip portion and/or the outer cylinder portion, and when the specimen holder is installed on an electron microscope, a support portion through which at least an electrode or a flow path passes, at a position further outward from the center than the position of the goniometer stage of the electron microscope.

2. The specimen holder according to claim 1, wherein the specimen holder shaft portion has a groove.

3. The specimen holder according to claim 1 or 2, wherein the specimen holder tip portion is retractable into the outer cylinder portion.

4. The specimen holder according to any one of claims 1 to 3, further comprising a cooling portion capable of cooling the specimen holder shaft portion.

5. The specimen holder according to any one of claims 1 to 3, wherein at least a part of the support portion is capable of transferring heat from the cooling portion to the specimen holder shaft portion.

6. A specimen holder according to any one of claims 1 to 5, further comprising a partition member that separates the inside of the outer cylinder portion from the atmosphere at a position further outward from the center than the position of a goniometer stage of the electron microscope when the specimen holder is installed in the electron microscope.

7. The specimen holder according to claim 6, wherein the partition member is installed at a connection portion between the outer cylinder portion and the specimen holder handle portion.

8. The specimen holder according to claim 6 or 7, wherein the partition member is disposed inside the specimen holder handle portion.

9. The specimen holder according to any one of claims 1 to 8, wherein the specimen holder shaft portion is rotatable around the specimen holder axis.

10. A specimen holder as described in claim 9, wherein the rotation allows the specimen and/or specimen mesh mounting portion to rotate around the axis of the specimen holder shaft portion or around an axis perpendicular to the axial direction of the specimen holder shaft portion.

11. The specimen holder according to any one of claims 1 to 10, wherein an outer wall surface of the specimen holder shaft portion and an inner wall surface of the outer cylinder portion are mirror-finished.
